Europäisches Patentamt

European Patent Office

Office européen des brevets

(19)

(11) Publication number: **0 198 569**
**A1**

# EUROPEAN PATENT APPLICATION

(12)

(21) Application number: **86300246.5**

(22) Date of filing: **15.01.86**

(51) Int. Cl.⁴: **H 01 L 27/08, H 01 L 27/06**

(30) Priority: **14.02.85 GB 8503794**

(43) Date of publication of application: **22.10.86**
**Bulletin 86/43**

(84) Designated Contracting States: **BE DE FR**

(71) Applicant: **SILICONIX LIMITED, Llanllienwen Close,**
**Morriston Swansea SA6 6NE (GB)**

(72) Inventor: **Davies, Stephen, 43 Greenwood Drive Cimla,**
**Neath West Glamorgan Wales (GB)**
Inventor: **Davies, Keith, 8 Llwyn-gog Parc Gwernfadog,**
**Morriston Swansea West Glamorgan (GB)**

(74) Representative: **Cross, Rupert Edward Blount et al,**
**BOULT, WADE & TENNANT 27 Furnival Street, London**
**EC4A 1PQ (GB)**

(54) **Monolithic integrated circuits having protection against latch-up.**

(57)    It is well known that in certain structures of monolithic integrated circuitry, parasitic thyristor action (via 18–10–11–13) can lead to latch-up and subsequent destruction of the circuit. This specification discloses a totally isolated diode (40) in series with a supply terminal to the circuit: in normal operation such a diode (40) would be forward biased, but under the conditions required for latch-up, it becomes reverse biased, preventing the current flow that would otherwise allow the thyristor to turn on.

EP 0 198 569 A1

0198569

IMPROVED MONOLITHIC INTEGRATED CIRCUITS

The present invention is concerned with monolithic integrated circuits and in particular with integrated circuits which have a parasitic four layer structure of alternating polarity types.

It is well known that the structure of integrated circuits can lead to the formation of parasitic devices and structures which are not intended to be included in the circuit design. Some integrated circuit designs include parasitic four layer structures of the kind which can in certain circumstances operate in the manner of a silicon controlled rectifier. If such a parasitic SCR is "fired" due to certain voltage conditions applied to the circuit, this can lead to destruction of the circuit.

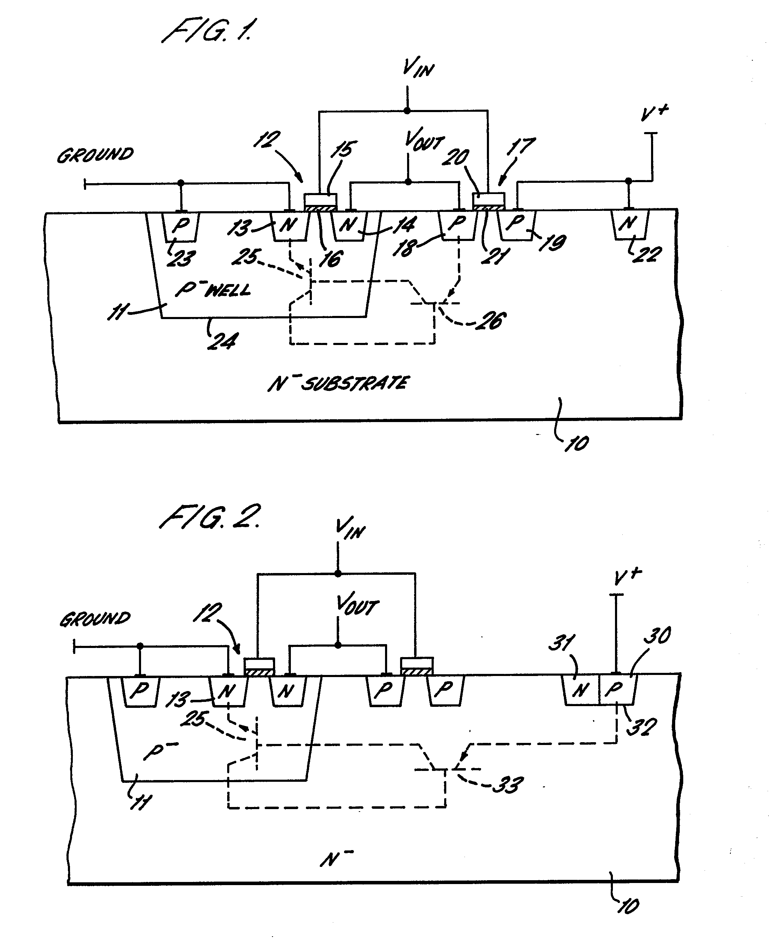

An example of a parasitic four layer structure in an integrated circuit is illustrated in figure 1 of the accompanying drawings. This shows, in a diagrammatic cross section through the thickness of a silicon substrate 10 of $N^-$ doping, a well 11 of $P^-$ doped material. Formed in the well 11 there is an oxide insulated gate field effect transistor 12 formed as an N-channel device with 2 N-type doped regions 13 and 14. A gate electrode 15 is insulated by an oxide layer 16 from the surface of the silicon material, to provide an N-channel MOS FET device in the usual way. A second, P-channel, device 17 is formed in the substrate 10 outside the $P^-$ well and comprises two P-regions 18 and 19 with a gate electrode 20 insulated from the substrate by an oxide layer 21. A supply voltage $V^+$ is applied via an N doped region 22 to maintain the substrate at the supply voltage level. In turn, the $P^-$ well is maintained at ground by a connection via a P doped region 23. Thus, in normal operation, the supply voltages applied to the substrate and the $P^-$ well operate to maintain the junction 24 between the $P^-$ well and the $N^-$ substrate reverse biased, thereby isolating the N-channel device 12 from the P-channel device 17.

The devices 12 and 17 are in the present illustrated case connected to provide an inverting function. Thus the positive voltage $V^+$ is connected to terminal 19 of the transistor 17 and the ground voltage is connected to the terminal 13 of the device 12. If an input voltage $V_{in}$ is applied as shown to the gate electrodes 15 and 20, an output voltage $V_{out}$ may be taken from the terminals 14 and 18 of the devices 12 and 17 respectively which is the inverse of the input voltage.

In normal operation this circuit can operate quite satisfactorily. However, it can be seen that there is in the circuit a four layer structure comprising for example, the terminal 13 of device 12 (N-type), the $P^-$ well 11, the $N^-$ substrate 10 and the terminal 18 of the device 17 (P-type). This four layer structure corresponds to the structure used in a SCR which can be switched to a conducting state if a forward bias current is passed through one of the outer two junctions of the device.

The four layer structure can be viewed as a parasitic npn transistor 25 and a parasitic pnp transistor 26. The parasitic transistor 25 has an emitter constituted by the terminal 13, a base constituted by the P⁻ well 11 and a collector consituted by the N⁻ substrate 10. The parasitic transistor 26 has an emitter constituted by the terminal region 18, a base constituted by the N⁻ substrate 10 and a collector constituted by the P⁻ well 11. The two parasitic transistors are connected together as illustrated by the ghost images of these transistors in figure 1.

In normal operation of the integrated circuit illustrated in figure 1, the junction between the terminal region 18 and the substrate 10 is maintained reverse biased, and no forward bias voltage is applied across the junction between the terminal region 13 and the P⁻ well 11. Thus, the parasitic four layer structure remains inactive. However, in certain circumstances one of these junctions may become forward biased. For example, if the voltage $V_{out}$ exceeds the supply voltage $V^+$ (e.g. through connectinon in a circuit prior to application of the supply voltages) the pn junction between the region 18 and the substrate 10 may become forward biased resulting in a base emitter current flowing in the parasitic transistor 26. This in turn may result in the transistor 26 turning on so that current can flow across the reverse biased junction 24 of the P⁻ well 11. This current will forward bias the junction between the P⁻ well and the N-type region 13 turning on the parasitic transistor 25. In accordance with the known operation of transistors connected as illustrated in figure 1, there will be a cumulative or runaway effect if the product of the current gains of the two transistors 25 and 26 is greater than unity, resulting in effective "firing" of the parasitic SCR.

Once the firing of the SCR initiates, the process is irreversable, even if the voltage $V_{out}$

falls again below $V^+$. There will effectively be a short circuit between the positive rail and ground through the circuit resulting in its destruction.

The present invention has the object of preventing such firing of the parasitic SCR in monolithic integrated circuits.

According to the present invention, a monolithic integrated circuit having a parasitic four layer structure of alternating polarity types and supply terminals for connection to a supply to keep an intermediate junction between layers of the structure reverse biased includes at least one totally isolated diode in series with one of said terminals and oriented to be normally forward biased by the supply. The totally isolated diode prevents a current flowing in the reverse direction to the supply terminal in question in the event that a voltage in excess of (or lower than) the supply terminal is applied to the circuit by means of one of the other input or output terminals. By using a totally isolated diode, the production of an alternative four layer structure in this case is avoided.

The totally isolated diode is fully incorporated in the monolithic integrated circuit but is totally isolated therefrom, e.g. by means of an oxide insulating layer.

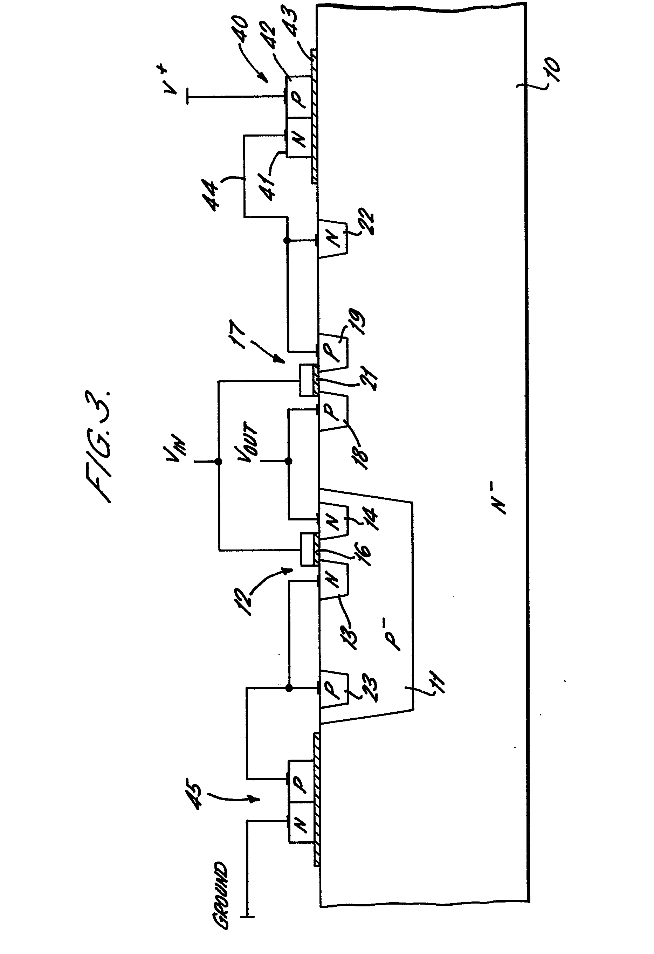

Figure 2 of the accompanying drawings illustrates a circuit in which a junction diode is employed in series with a positive voltage rail $V^+$, formed by doping the substrate 10. The junction diode is formed of a P-type doped region 10 forming a junction with an N-doped region 31. Unfortunately, the diode forms a forward biased pn junction 32 between the region 30 and the substrate 10 resulting in a four layer structure comprising the region 30, the substrate 10, the P⁻ well 11 and the region 13 of the device 12. Normal operation of the device results in the junction 32 being forward biased, tending to turn on the parasitic transistor 33 formed by the regions 30, 10 and 11. Thus the use of a junction diode as illustrated in figure 2 makes matters worse in that an SCR structure is thereby formed which may readily be fired resulting in destruction of the circuit.

Conveniently, the totally isolated diode employed in the present invention is a polysilicon diode formed on a surface of the integrated circuit substrate and insulated therefrom by an oxide layer.

It will be appreciated that the parasitic four layer structure in the circuit can be "fired" by a forward bias current across either of the outer two junctions. The provision of a single totally isolated diode on one of the supply lines only prevents a forward bias current flowing across the adjacent outer junction.

Preferably, therefore, a respective said totally isolated diode is provided in series with each of said terminals.

Typically, the parasitic four layer structure is formed by junction isolation of one device in the integrated circuit from another.

Thus, the circuit may comprise a substrate of a first polarity type, a well region of a second polarity type in the substrate, a first device formed in said well region including a first further region of the first polarity type, a second device formed in the substrate outside the well region and including a second further region of the second polarity type, supply terminals to the substrate and said well region connectable to a supply to keep the junction between the well region and the substrate reverse biased. Normally, said first and second polarity types mentioned above are N and P types respectively and said first device is an N-channel CMOS FET and said second device is a P-channel CMOS FET.

Examples of circuits incorporating the invention are CMOS inverters and CMOS analogue switches.

In the accompanying drawings,

Figure 1 is a schematic cross sectional view of a monolithic integrated circuit constituting an inverter and illustrating the problem of the prior art;

Figure 2 is a schematic cross sectional view of a monolithic integrated circuit illustrating the problem using an integrated junction diode in series with a supply line;

Figure 3 is a schematic cross sectional view of a monolithic integrated circuit constituting an inverter and incorporating totally isolated diodes embodying the present invention and

Figure 4 is a schematic cross sectional view of a monolithic integrated circuit also embodying the present invention and constituing an analogue switch.

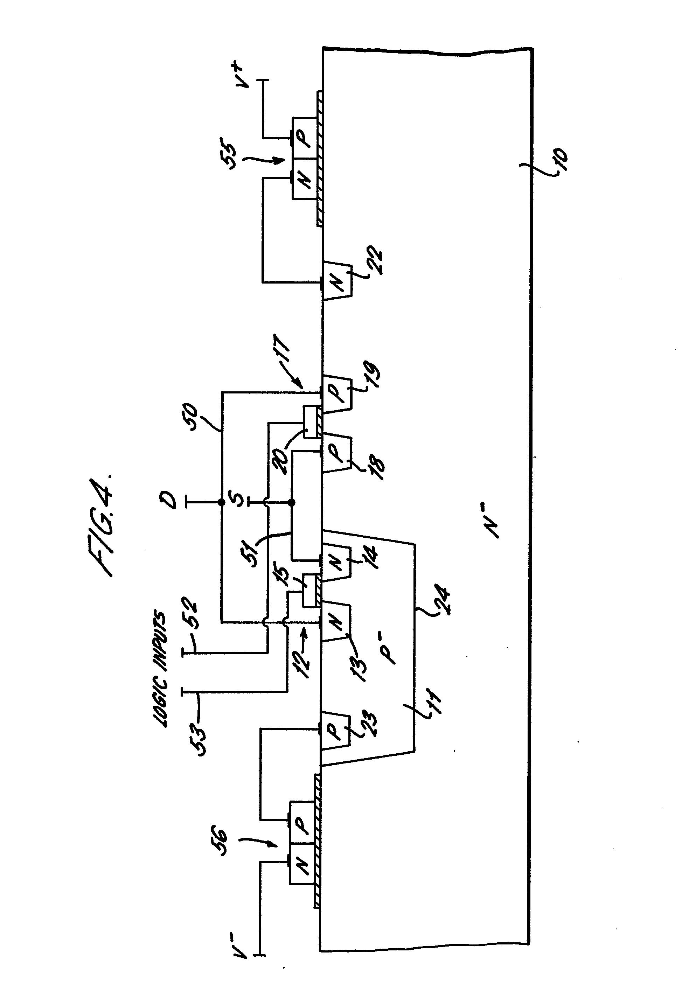

Referring firstly to figure 3, references corresponding to those used earlier in describing figures 1 and 2 are used again for corresponding components in the example illustrated in figure 3. Thus, an N-channel MOS FET 12 is formed in a $P^-$ well 11 in an $N^-$ substrate 10, and a P-channel MOS FET 17 is formed directly in the substrate 10. There is thus produced a parasytic four layer structure comprising one N-type region 13 of the transistor 12, the $P^-$ well 11, the $N^-$ substrate 10 and one P-type region 18 of the transistor 17.

The positive rail supply is supplied directly to the substrate 10 via an N-doped region 22, and also to the other P-doped region 19 of the transistor 17. The positive rail is however supplied via the totally isolated diode indicated generally at 40. The diode 40 comprises adjacent N-type and P-type polysilicon layers 41 and 42 formed on an insulating layer 43 typically of oxide. The positive supply $V^+$ is connected to the P-type layer 42 and the N-type layer 41 is connected by a line 44 to the N-type contact region 22 and the P-type terminal 19 of the transistor 17.

The N and P regions 41 and 42 of the polysilicon diode 40 may be formed by doping the polysilicon. The oxide layer 43 may itself be formed at the same time as the field insulating oxide layer. The line 44 may be provided by any suitable conducting layer formed by known processes on the surface of the silicon chip.

In figure 3, a second totally isolated diode 45 is also shown provided in series between Ground and the P-type region 23 in the $P^-$ well 11. The diode 45 is constructed in the same way as the diode 40.

In operation, if $V_{out}$ should exceed the voltage of the substrate 10, no current can flow across the forward biased pn junction between region 18 and the substrate 10 because such a current is blocked by the diode 40. Accordingly, the parasitic transistor 26 (figure 1) is not turned on so that there is no tendancy for the four layer structure to be fired.

Similarly, should $V_{out}$ fall below the voltage of the $P^-$ well, no forward bias current can flow across the junction between the well 11 and the N-type region 14 of transistor 12 because of the blocking effect of the diode 45. Thus there is no tendancy for a parasitic transistor formed by the regions 14, 11 and 10 to be turned on.

It can be seen, therefore, that the totally isolated diodes 40 and 45 fully protect the integrated circuit from activation of the four layer structure inherent and parasitic in the device when input-output terminals are subject to overvoltages. Figure 4 illustrates a further example of the invention which constitutes an analogue switch. Again, an N-channel MOS FET 12 is formed in a $P^-$ well 11 and a P-channel MOS FET 17 is formed in the $N^-$ substrate 10. However in this example, one N-type region 13 of the transistor 12 is connected to one P-type region 19 of the transistor 17 and the other N-type region 14 is connected to the other P-type region 18. These two connections by means of lines 50 and 51 respectively form Drain and Source connections to the analogue switch. The switch is operated by logic inputs on lines 52 and 53 to the gate contacts 15 and 20. One logic input is normally the logic inverse of the other so that either both transistors 12 and 17 are turned on or both are turned off. The arrangement provides for an analogue gate which permits an analogue signal of either or alternating polarity to be switched.

A bias supply to the circuit is supplied to the substrate 10 via an N-doped region 22 and to the $P^-$ well 11 via a P-doped region 23. The bias is intended to maintain the junction 24 between the $P^-$ well 11 and the substrate 10 reversed biased thereby isolating the transistors 12 and 17. The analogue switch has a dynamic input voltage range from a minimum of the bias voltage applied to the $P^-$ well 11 (about $V^-$) up to a maximum of the bias voltage applied to the substrate 10 (about $V^+$).

The bias voltages $V^+$ and $V^-$ are applied via respective totally isolated polysilicon diodes 55 and 56 respectively. The diodes 55 and 56 are formed in the same way as described for figure 3.

It can be seen that the illustrated circuit has a parasitic four layer structure. For example, if the voltage on the Source terminal (line 51) exceeded the bias voltage of the substrate 10 the pn junction between region 18 and the substrate could become forward biased. However, the diode 55 blocks any forward bias current flowing thereby preventing turning on of the parasitic transistor comprising the region 18, the substrate 10 and the $P^-$ well 11. On the otherhand, if the voltage on the source terminal fell below the bias voltage of the $P^-$ well 11, the junction between the $P^-$ well and the region 14 could become forward biased but the diode 56 blocks any forward biased current thereby preventing turning on the parasitic transistor formed by the region 14, and the $P^-$ well 11 and the substrate 10.

It will be appreciated that the generality of the invention is applicable to other examples of monolithic integrated circuit in which there is a parasitic four layer structure capable of being fired in certain circumstances.

CLAIMS:

1.　A monolithic integrated circuit having a parasitic four layer structure of alternating polarity types (18-10-11-13), and supply terminals for connection to a supply to keep an intermediate junction between layers of the structure reverse biased, wherein the circuit includes at least one totally isolated diode (40, 45) in series with one of said terminals and oriented to be normally forward biased by the supply.

2.　A monolithic integrated circuit as claimed in claim 1 wherein the totally isolated diode (40, 45) is a polysilicon diode formed on a surface of the integrated circuit substrate and insulated therefrom by an oxide layer (43).

3.　-A monolithic integrated circuit as claimed in either claim 1 or claim 2 wherein a respective said totally isolated diode (40, 45) is provided in series with each of said terminals.

4.　A monolithic integrated circuit as claimed in any of claims 1 to 3 wherein the parasitic four layer structure (18-10-11-13) is formed by junction isolation of one device in the integrated circuit from another.

5.　A monolithic integrated circuit as claimed in claim 4 and comprising

a substrate of a first polarity type (10),

a well region of a second polarity type in the substrate (11),

a first device formed in said well region (11) including a first further region of the first polarity type (13),

a second device formed in the substrate outside the well region and including a second further region of the second polarity type (18),

supply terminals to the substrate (10) and said well region (11) connectable to a supply to keep the junction between the well region (11) and the substrate (10) reverse biased.

6. A monolithic integrated circuit as claimed in claim 5 wherein said first and second polarity types are N and P types respectively and said first device is an N-channel CMOS FET and said second device is a P-channel CMOS FET.

7. A monolithic integrated circuit as claimed in claim 6 and constituting a CMOS inverter.

8. A monolithic integrated circuit as claimed in claim 6 and constituting a CMOS analogue switch.

## FIG. 1.

V_IN

GROUND

12  15  V_OUT  20  17  V+

P | N | N | P | P | N
23 | 13 | 14 | 18 | 21 | 19 | 22
25 | 16 | 26

11  P⁻ WELL

24

N⁻ SUBSTRATE

10

## FIG. 2.

V_IN

GROUND

V_OUT

12  31  30

P | N | N | P | P | N | P
13 | 25 | 33 | 32

11  P⁻

N⁻

10

V+

FIG. 3.

GROUND

45

$V_{IN}$

$V_{OUT}$

$V^+$

44

40

41

42

43

12

17

N  P

N

13

P

23

N

16

N

14

P

18

P

21

P

19

N

22

N  P

$P^-$

11

$N^-$

10

0198569

FIG.4.

**European Patent Office**

**EUROPEAN SEARCH REPORT**

EP 86 30 0246

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | WO-A-8 102 949 (WESTERN ELECTRIC CO.) * abstract; claims 1, 2 * | 1 | H 01 L 27/08 H 01 L 27/06 |
| A | GB-A-1 542 481 (TOKYO SHIBAURA ELECTRIC CO.) * page 2, lines 42-65; page 3, lines 65-76 * | 1 | |

**TECHNICAL FIELDS SEARCHED (Int. Cl.4)**

H 01 L 27/02
H 01 L 27/06
H 01 L 27/08

The present search report has been drawn up for all claims

| Place of search | Date of completion of the search | Examiner |
|---|---|---|
| BERLIN | 10-04-1986 | PRETZEL B.C. |